(19) Europäisches Patentamt
European Patent Office
Office européen des brevets

(11) **EP 4 362 311 A1**

(12) **EUROPEAN PATENT APPLICATION**

(43) Date of publication:
**01.05.2024 Bulletin 2024/18**

(21) Application number: **22204176.6**

(22) Date of filing: **27.10.2022**

(51) International Patent Classification (IPC):
***H02M 7/487*** *(2007.01)*

(52) Cooperative Patent Classification (CPC):
**H02M 7/487**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ABB SCHWEIZ AG**
**5400 Baden (CH)**

(72) Inventors:
- **DORFLING, Martinus David**
  **5400 Baden (CH)**
- **GEYER, Tobias**
  **5408 Ennetbaden (CH)**

(74) Representative: **Sykora & König Patentanwälte PartG mbB**
**Maximilianstraße 2**
**80539 München (DE)**

(54) **CONVERTER-FRIENDLY OPTIMIZED PULSE PATTERNS**

(57) A method for computing an optimized pulse pattern (20) for an electrical converter (18) is presented. The optimized pulse pattern (20) comprises a series of switching transitions, each switching transition comprising a switching angle ($\alpha_i$) and a switch position ($u_i$). The switching angles ($\alpha_i$) are computed by minimizing a total demand distortion of a load current produced by the optimized pulse pattern (20), wherein an objective function is minimized, which models the total demand distortion of a load current in dependence of the switching angles ($\alpha_i$) and switch positions ($u_i$). The total demand distortion of the load current is minimized subject to at least one additional constraint, which limits a turn-off current, and/or a switching loss, a temperature and/or a voltage to be blocked for a set of semiconductor devices (26) of the electrical converter (18).

**Fig. 2**

Angle $\theta$ [rad]

# Fig. 3

**Description**

FIELD OF THE INVENTION

The invention relates to a method, a computer program, a computer-readable medium and a computing device for computing optimized pulse patterns.

BACKGROUND OF THE INVENTION

Optimized pulse patterns (OPPs) are a specific pulse width modulation (PWM) method in which the switching signal is computed offline by formulating and solving an optimization problem. Compared to classic modulation methods such as carrier-based PWM or space vector modulation, the power capability of an electrical converter can be maximized by adopting OPPs as modulation method. The maximization of the converter power is achieved in three dimensions by higher output voltages, higher output currents and less or no derating of the converter current at high fundamental frequencies.

Higher output voltages are attained thanks to the seamless extension of OPPs from the extended linear modulation regime (up to modulation index $m = 2/\sqrt{3} = 1.155$) to the nonlinear modulation regime up to block mode with modulation index $m = 4/\pi = 1.273$.

Achieving higher output currents and minimizing derating at high fundamental frequencies, however, are challenging. The achievable output converter current is predominantly limited by the choice of semiconductors. These dominate the bill of material of the converter. Therefore, from an economic point of view, it is desirable to maximize their power capability.

The operation of switches and diodes is limited by their safe operating area, which is defined with respect to the junction temperature, the turn-off current, and the blocking voltage. Switching and conduction losses cause thermal losses that are transferred by the semiconductor housings and heatsink to the water-cooling circuitry. The heat removal capability of the latter is limited and strongly depends on the thermal resistance of the heatsink, the cooling water temperature and its flow rate. The switching losses are proportional to the commutated current, the blocking voltage and the switching frequency. The conduction losses depend on the phase current. The thermal balance between the generation of heat in the semiconductors and the heat removal by the water-cooling circuit can be accurately modelled using a transient thermal impedance model. This allows one to determine the junction temperature of the semiconductors. During the converter operation, the maximum junction temperature must be kept below a semiconductor-specific maximum value to avoid a thermal runaway that can lead to a short circuit, to minimize the thermal cycling stress that can lead to premature failure of the semiconductor and the creating of new charge carriers that would turn the semiconductor into a conductor.

A second dimension is the turn-off current. Semiconductor switches such as gate-commutated thyristors in particular have a well-defined and limited maximum current that can be turned off safely without reducing their expected lifetime. To avoid premature failures, this limit must be adhered to.

The device blocking voltage plus the voltage overshoot during switching events strongly determines the failure rate of the semiconductors, for example due to cosmic rays. For this reason, the device blocking voltage needs to be kept below a semiconductor-specific value.

The classic approach to address these challenges and to ensure the safe operation of the semiconductors is as follows.

To limit the junction temperature, the switching frequency is limited below the maximal switching frequency $f_{sw,max}$. For a given fundamental frequency $f_1$, the pulse number $d$ is chosen as the largest integer that does not exceed $f_{sw,max}/f_1$, i.e.,

$$d = \text{floor}(f_{sw,max}/f_1).$$

OPPs being a synchronous modulation scheme leads to the well-known steps in the switching frequency. Particularly at low pulse numbers, the switching frequency is often significantly lower than its maximum value, resulting in a poor utilization of the thermal capability of the semiconductors. Owing to the strongly varying phase current within a fundamental period it is also apparent that the switching frequency only mildly correlates with the overall switching losses and the peak junction temperature.

To reduce the turn-off current, the phase current is reduced and the required minimum load inductance is increased to reduce the current ripple.

To reduce the blocking voltage, the capacitance in the dc-link is increased, the total dc-link voltage is reduced and the phase current is reduced.

DESCRIPTION OF THE INVENTION

The classic approach described above fails to maximize the capability of the power converter and to increase the output current close to the physical limits of the converter.

It is an objective of the invention to provide optimized pulse patterns, which increase the output current of an electrical converter and keep the semiconductors of the electrical inverter within safe operation conditions.

This objective is achieved by the subject-matter of the independent claims. Further exemplary embodiments are evident from the dependent claims and the following description.

A first aspect of the invention relates to a method for computing an optimized pulse pattern for an electrical converter. Usually, a set of optimized pulse patterns will be computed for a plurality of pulse numbers and modulation indices. The method may be performed by a computing device, which computes the optimized pulse patterns. The set of optimized pulse patterns then may be stored in a controller of the electrical converter, which set is then used for modulating the electrical converter during operation.

According to an embodiment of the invention, the optimized pulse pattern comprises a series of switching transitions, wherein each switching transition comprises a switching angle $\alpha_i$ and a switch position $u_i$ with $i \in \{1,2, ...,4d\}$. The number of switching transitions in a fundamental period is $4d$, where $d$ is the pulse number of the optimized pulse pattern. The switching angles may be angles between 0 and 360°. The switch positions may be the numbers $\{-1,0,1\}$, however, also converters with more than three output voltages per phase may be considered.

It has to be noted that the electrical converter may have more than one phase and that the optimized pulse pattern is applied phase-shifted by 120° in each phase.

According to an embodiment of the invention, the switching angles are computed by minimizing a total demand distortion of a load current produced by the optimized pulse pattern, wherein an objective function is minimized, which models the total demand distortion of a load current in dependence of the switching angles and switch positions. When the optimized pulse pattern is used for modulating the electrical converter, a load current is generated in a load connected to the electrical converter. This load current, for example for an inductive load, can be computed and can be used for optimizing the optimized pulse pattern. The formula for the total demand distortion of the load current can be used as objective function in an optimization problem for optimizing the optimized pulse pattern, such formulas are provided below with equations (12a) and (13a). In the present application, the load current and a phase current through the output phases of the electrical converter can be considered equal.

According to an embodiment of the invention, the total demand distortion of the load current is minimized subject to one or more constraints, which limit a quantity from at least one of a turn-off current, a switching loss, a temperature and a voltage to be blocked. The limitation for the respective quantity are imposed for a set of semiconductor devices of the electrical converter. The optimization problem may be supplemented with constraints, such that not only the total harmonic distortion is minimized, but that also further conditions are met by the optimized pulse pattern. In particular, constraints, which assure that the semiconductor devices of the electrical converter stay within limits in view of specific physical parameters, may be applied.

The semiconductor devices may comprise the semiconductor switches of the electrical converter, such as transistors, thyristors and the diodes. Also a subset of these semiconductor devices may be considered.

The one or more quantities to be constrained during operation of the electrical converter may be chosen to achieve a converter-friendly operation. This is achieved by focusing on the most critical components of a converter, the power semiconductor devices. Their safe operating area may be defined in terms of the maximum tolerable junction temperature, switching losses, a maximum turn-off current and/or peak blocking voltage. By modelling one or more of these quantities in terms of the to-be-computed optimized pulse patterns switching angles, phase current and semiconductor cooling capability, the safe operating area can be added to the OPP optimization problem in the form of constraints.

The constraints are derived in the form of mathematical equations, based on which closed-form derivatives can be computed. As objective function, an expression for the current harmonics of an inductive load may be used, which models the total harmonic distortion of the load current. By minimizing the objective function subject to the constraints of the safe operating area, optimized pulse patterns may be derived that ensure operation within the safe operating area.

According to an embodiment of the invention, the one or more quantities being at least one of a turn-off current, a switching loss, a temperature and a voltage to be blocked for a set, which define the safe operation area, depend on the switching angles and the switch positions. The constraint equations used for limiting the one or more quantities are modelled depending on the parameters and variables of the optimized pulse pattern, i.e. on the switch positions and the switching angles, respectively.

According to an embodiment of the invention, at least one constraint for the quantity is present for each semiconductor device from the set of semiconductor devices. The optimization problem may be formulated that not only global, classical constraints, such as formulas (12b-c) and/or (13b-c) below, but constraints depending on specific semiconductor devices are used. For example, for each semiconductor device, there may be a constraint limiting at least one of its turn-off current, its switching losses, its temperature and/or its blocking voltage.

According to an embodiment of the invention, the quantity, which is constrained, depends on a displacement angle, which is the phase of a fundamental component of the load current with respect to a fundamental voltage component of an output voltage produced by the optimized pulse pattern, when the electrical converter is modulated with it. In this case, corresponding constraints are imposed with respect to a set of relevant displacement angles on the optimization problem. For example, the set of relevant displacement angles may comprise angles over the complete angle range from 0 to 360°.

According to an embodiment of the invention, the total demand distortion of the load current is minimized subject to current limiting constraints, which constrains that a peak current produced by the optimized pulse pattern at each switching transition is smaller than or equal to a limiting current. The peak current also may depend on the displacement angle. Formula (15) below shows such a constraint.

According to an embodiment of the invention, the total demand distortion of the load current is minimized subject to loss constraints that semiconductor losses are smaller than limiting losses. Formulas (16) and (17) below show such constraints, in particular for average semiconductor losses. In general, the semiconductor losses may be average semiconductor losses and/or peak semiconductor losses. It may be that average semiconductor losses are constrained and/or that peak semiconductor losses are constrained. The following may apply to average semiconductor losses and/or peak semiconductor losses.

It may be that a semiconductor loss is determined for each semiconductor device from the set of semiconductor devices and/or that the semiconductor loss of a semiconductor device is the sum of a switching loss and a conduction loss of the semiconductor device.

Again, the semiconductor losses may depend on the displacement angle and the loss constraints are imposed with respect to a set of relevant displacement angles.

According to an embodiment of the invention, for each semiconductor device of the set of semiconductor devices, a loss constraint is present, which constrains that the semiconductor loss of the semiconductor device is smaller than a limiting loss for the semiconductor device. It may be that the losses are considered individually for every semiconductor device.

According to an embodiment of the invention, a loss constraint is present, which constrains that the sum of semiconductor losses of the set of semiconductor devices is smaller than an overall limiting loss. In this case, there may be solely one loss constraint, which considers all semiconductor devices at once.

According to an embodiment of the invention, the total demand distortion of the load current is minimized subject to temperature constraints, which constrain the average temperatures, instantaneous temperatures, and/or temperature ripples of semiconductor devices from the set of semiconductor devices are smaller than limiting temperatures. Examples for temperature constraints are provided in equations (19), (20) and (21) below.

Based on a thermal model of a semiconductor device and the thermal connected components of the electrical converter, from the losses in the semiconductor device, the temperature of the semiconductor device can be modelled and constraint equations can be derived. An example for such a thermal model is a Foster thermal model. The thermal connected components of the electrical converter may comprise a heat sink and/or a cooling circuit.

According to an embodiment of the invention, an average temperature, instantaneous temperature, and/or a temperature ripple is determined for each semiconductor device from the set of semiconductor devices. The average temperature and/or the temperature ripple may be modelled individually for every semiconductor device. These average temperatures, instantaneous temperatures, and/or a temperature ripples may be included into one or more temperature constraints.

The average temperatures, instantaneous temperatures, and/or temperature ripples may depend on the displacement angle and the temperature constraints may be imposed with respect to the set of relevant displacement angles.

According to an embodiment of the invention, for each semiconductor device of the set of semiconductor devices, at least one temperature constraint is present, which constrains that the average temperature, instantaneous temperatures, and/or temperature ripple of the semiconductor device is smaller than a limiting temperature. It may be that the corresponding quantities are limited for each semiconductor device individually.

According to an embodiment of the invention, the total demand distortion of the load current is minimized subject to a neutral-point potential constraint that a neutral-point potential is smaller than a limiting neutral-point voltage. Such a constraint may be as in equation (25).

According to an embodiment of the invention, the total demand distortion of the load current is minimized subject to a dc-link ripple constraint that a dc-link ripple is smaller than a limiting dc-link ripple voltage. Such a constraint may be as in equation (26).

The voltage to be blocked by each semiconductor device may be limited by constraining the neutral-point potential and/or the dc-link ripple.

Again, the constraint equations for the neutral-point potential and/or the dc-link ripple may depend on the displacement angle and the neutral-point potential constraint and/or dc-link ripple constraint are imposed with respect to a set of relevant displacement angles.

According to an embodiment of the invention, the total demand distortion of the load current is minimized subject to the (classical) constraint that the order of the switching transitions is fixed, see for example equation (12c) below. In this way it may be ensured that switching transitions do not change place in the series of switching transitions.

According to an embodiment of the invention, the total demand distortion of the load current is minimized subject to the (classical) constraint that an amplitude of the fundamental component is equal to a modulation index $m$, see for example equation (12b) below. In such a way, the modulation index of the optimized pulse pattern may be set.

A further aspect of the invention relates to a method for controlling an electrical converter, which method comprises: computing optimized pulse patterns for a plurality of pulse numbers and modulation indices, such as described above and below; storing the optimized pulse patterns in a controller of the electrical converter; and controlling, by the controller, the electrical converter with the optimized pulse patterns. The optimized pulse patterns may be computed offline, for example during commissioning of the electrical converter and then stored in its controller. During operation of the electrical converter, an actual pulse number and modulation index may be determined, the corresponding optimized pulse pattern may be loaded and the electrical converter may be modulated with this optimized pulse pattern.

A further aspect of the invention relates to a computer program, which, when being executed on at least one processor, is adapted for performing the method as described herein. The computer program may be performed in a computing device for computing the optimized pulse patterns and optionally in a controller of the electrical converter.

A further aspect of the invention relates to a computer-readable medium, in which such a computer program is stored. Such a computer-readable medium may be the memory of the computing device and optionally of the controller.

In general, a computer-readable medium may be a hard disk, an USB (Universal Serial Bus) storage device, a RAM (Random Access Memory), a ROM (Read Only Memory), an EPROM (Erasable Programmable Read Only Memory) or a FLASH memory. A computer-readable medium may also be a data communication network, e.g. the Internet, which allows downloading a program code. In general, the computer-readable medium may be a non-transitory or transitory medium.

A further aspect of the invention relates to a computing device adapted for performing the method as described herein. Such a computing device may be a PC. It has to be understood that features of the method as described herein may be features of the computing device as described herein, and vice versa.

These and other aspects of the invention will be apparent from and elucidated with reference to the embodiments described hereinafter.

BRIEF DESCRIPTION OF THE DRAWINGS

The subject-matter of the invention will be explained in more detail in the following text with reference to exemplary embodiments which are illustrated in the attached drawings.

Fig. 1 schematically shows a system with a computing device and converter system according to an embodiment of the invention.

Fig. 2 shows a diagram illustrating an optimized pulse pattern.

Fig. 3 shows a diagram with a current constraint according to an embodiment of the invention.

Fig. 4 shows a diagram with loss constraints on semiconductor losses according to an embodiment of the invention.

Fig. 5 shows a diagram with a temperature constraint on semiconductor device temperatures according to an embodiment of the invention.

Fig. 6 schematically shows converter legs and conduction paths of an electrical converter.

Fig. 7 shows diagrams with a hyperbolic-based extractor function for decomposing the phase current into its positive and negative phase currents in an electrical converter.

Fig. 8 shows diagrams with a step-function-based extractor function for decomposing the phase current into its positive and negative components in an electrical converter.

Fig. 9 illustrates switching states and a device current of a semiconductor switch, when the optimized pulse pattern shown in Fig. 2 is used.

Fig. 10 shows a Foster thermal model of the heat transfer through a semiconductor module.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

INTRODUCTION

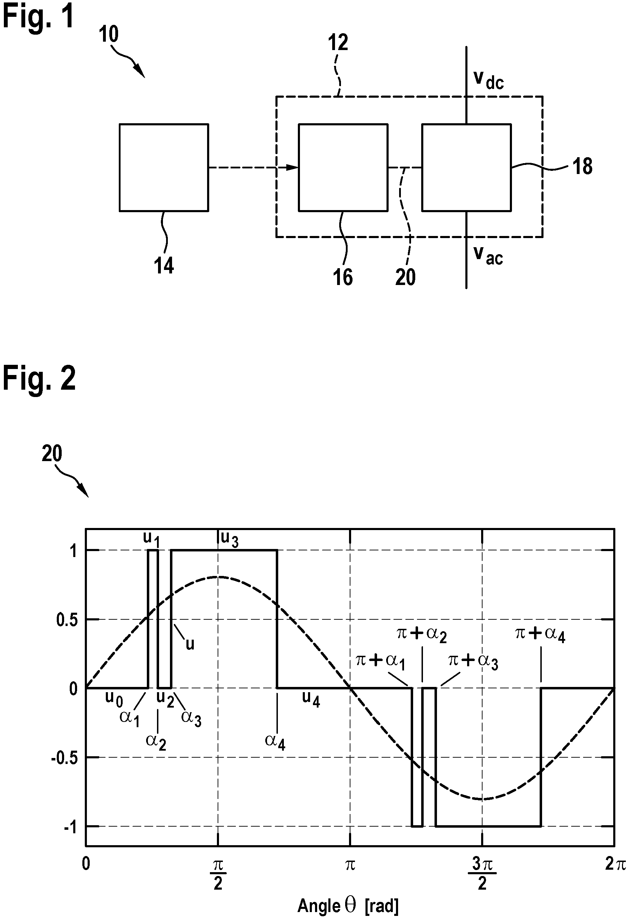

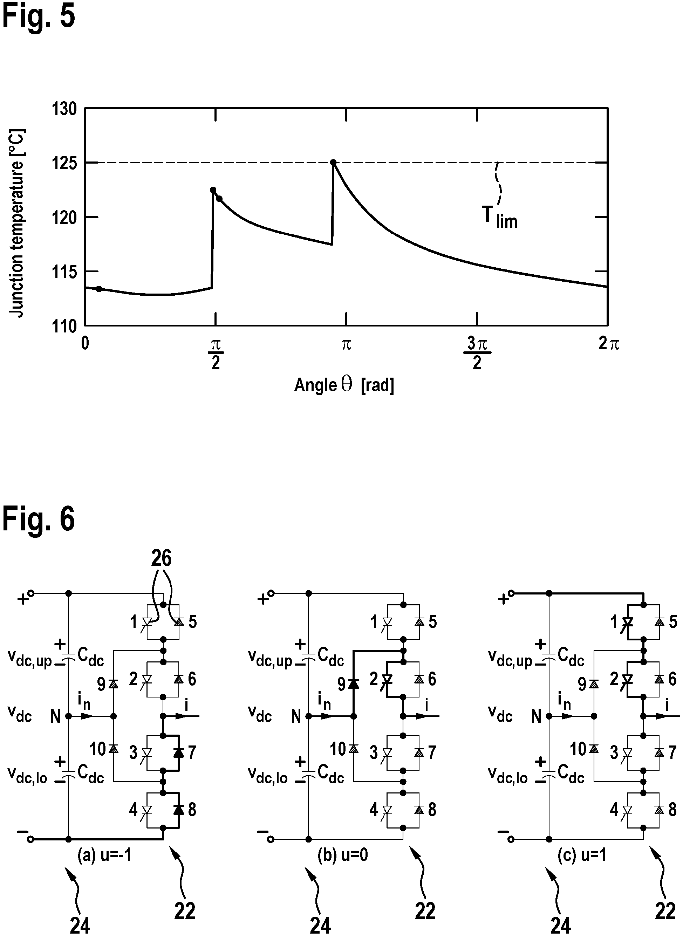

Fig. 1 shows a system 10, which comprises a converter system 12 and a computing device 14. The converter system 12 comprises a controller 16 and an electrical converter 18.
The controller 16 modulates the electrical converter 18 with optimized pulse patterns (OPPs) 20, which then convert a DC voltage $v_{dc}$ into an AC voltage $v_{ac}$. The DC voltage $v_{dc}$ may be provided by a dc-link with capacitors. The AC voltage $v_{ac}$ may be a three-phase voltage, which is generated by three phase legs of the electrical converter.
As an example, the electrical converter 18 may be a three-level neutral-point-clamped (NPC) medium-voltage converter with integrated-gate-commutated thyristors.
Phase legs 22 of such a converter 18 connected to a dc-link 24 are shown in Fig. 6. The dc-link 24 is a split dc-link. Each NPC phase leg 22 is composed of semiconductor devices 26 in the form of semiconductor switches and diodes.
More general, the electrical converter comprises active semiconductor devices, i.e. switches such as transistors and thyristors, and passive semiconductor devices, such as diodes. In the following, semiconductor switches are referred to as gate-commutated thyristors (GCT), however, also other types of semiconductor switches may be considered. Passive semiconductor devices may be freewheeling diodes and clamp diodes.
A set of optimized pulse patterns 20 is stored in the controller 16 and based on a modulation index $m$ and pulse number $d$, an optimized pulse pattern 20 is selected by the controller 16 and applied to the electrical converter 18. The same optimized pulse pattern 20 may be applied to each phase leg of the electrical converter 18 phase-shifted by 120°. This is done during operation of the electrical converter 18, i.e., online.
During commissioning of the electrical converter 18 or before, i.e. offline, the set of optimized pulse patterns 20 is computed by the computing device 14 such as described herein. The set of optimized pulse patterns 20 is then stored in the memory of controller 16.
Optimized pulse patterns are a specific pulse width modulation (PWM) method in which the switching signal is computed offline by formulating and solving an optimization problem. In the following, the focus is on three-level switching signals for three-level converters, but OPPs can be computed for converters with any number of voltage levels, including converters with two and five levels.
The switching frequency of the semiconductor devices is given by

$$f_{sw} = d f_1 \, , \qquad\qquad (1)$$

where $d$ is the pulse number and $f_1$ is the fundamental frequency of the switching signal.
Two assumptions may be universally made when computing OPPs:

- The switching signal is $2\pi$-periodic.
- The switching signal is three-phase symmetric.

This implies that the pulse number $d$ is an integer. In particular, OPPs are a synchronous modulation method.

*Switching signal*

The two assumptions made above imply that three-phase OPPs are fully characterised by the single-phase switching signal $u(\theta)$ with the (integer) switch position $u \in \{-1,0,1\}$ and the angle $\theta \in [0,2\pi]$ as argument. We impose half-wave symmetry (HWS) on the switching signal, i.e.,

$$u(\theta) = -u(\pi + \theta).$$

Fig. 2 shows an exemplary switching signal with half-wave symmetry and pulse number $d = 2$. The single-phase switching signal $u(\theta)$ is fully defined by the switching angles $\alpha_i$ with $i \in \{1,2, ...,2d\}$ and the switch positions $u_i$ with $i \in \{0,1, ... ,2d\}$, which also define the optimized pulse pattern 20. Note that imposing half-wave symmetry is not at the expense of generality. It is common practice to consider only non-negative switching signals in the positive half-wave of the fundamental period, i.e., $u(\theta) \geq 0$ for $[0,\pi]$. This implies that the polarity of the $2d$ switch positions is non-negative as well, i.e., $u_i \in \{0,1\}$ with $i \in \{0,1, ... ,2d\}$.

We also define the switching transition

$$\Delta u_i = u_i - u_{i-1}$$

as the change in switch position at the switching angle $\alpha_i$, where $i \in \{1,2, ... ,2d\}$. Because we consider only non-negative switch positions, the initial switch position $u_0$ is zero and the switching transitions are given by

$$\Delta u_i = (-1)^{i+1} \qquad (2)$$

with $i \in \{1,2, ... ,2d\}$. Note that considering only non-negative switch positions is not at the expense of generality.

*Harmonic analysis*

Owing to the $2\pi$-periodicity of the single-phase switching signal, it can be represented by the Fourier series

$$u(\theta) = \frac{a_0}{2} + \sum_{n=1}^{\infty} (a_n \cos(n\theta) + b_n \sin(n\theta)) \qquad (3)$$

with the Fourier coefficients $a_n$ of order $n \geq 0$ and $b_n$ of order $n \geq 1$.

For half-wave symmetric switching signals, the Fourier coefficients

$$a_n = \begin{cases} -\dfrac{2}{n\pi} \displaystyle\sum_{i=1}^{2d} \Delta u_i \sin(n\alpha_1), & n = 1,3,5 \ldots \\ 0, & n = 0,2,4, \ldots \end{cases} \qquad (4a)$$

$$b_n = \begin{cases} \dfrac{2}{n\pi} \displaystyle\sum_{i=1}^{2d} \Delta u_i \cos(n\alpha_1), & n = 1,3,5 \ldots \\ 0, & n = 2,4,6, \ldots \end{cases} \qquad (4b)$$

result. All harmonics of even order and the dc-offset are zero.

Often, quarter-wave symmetry

$$u(\pi - \theta) = u(\theta)$$

is imposed on the switching signal as well in addition to half-wave symmetry. We refer to this as quarter- and half-wave symmetry (QaHWS), which leads to the Fourier coefficients

$$a_n = 0, \qquad n = 0,1,2, \ldots$$

$$(5a)$$

$$b_n = \begin{cases} \dfrac{4}{n\pi} \displaystyle\sum_{i=1}^{d} \Delta u_i \cos(n\alpha_1), & n = 1,3,5 \ldots \\ 0, & n = 2,4,6, \ldots \end{cases} \qquad (5b)$$

In both cases, the amplitude $\hat{u}_n$ of the $n$th harmonic of the single-phase switching signal $u$ is given by

$$\hat{u}_n = \sqrt{a_n^2 + b_n^2}. \qquad (6)$$

Note that the amplitude of the fundamental component $\hat{u}_1$ is equal to the modulation index $m$, with $m \in [0, 4/\pi]$.

*Voltage and current harmonics*

For a three-level converter with a fixed, balanced dc-link, the amplitude of the $n$th voltage harmonic at the converter output is

$$\hat{v}_n = \frac{v_{dc}}{2} \hat{u}_n, \qquad (7)$$

where $v_{dc}$ is the dc-link voltage. Assume that the converter is connected to a purely inductive load with inductance L and a (three-phase) voltage source, such as an electrical machine with a certain back EMF for which the stator resistance is neglected. For induction machines, L is the total leakage inductance, whereas for an (externally excited) synchronous machine, L refers to the subtransient inductance. Alternatively, the converter may be connected to the grid; L then includes the sum of the transformer and grid inductances with any resistive or capacitive components neglected.
The amplitude of the $n$th current harmonic directly follows as

$$\hat{i}_n = \frac{\hat{v}_n}{n\omega_1 L}, \text{ for } n \neq 1, \qquad (8)$$

where $\omega_1 = 2\pi f_1$ is the angular fundamental frequency. Note that the amplitude of the fundamental current component, $\hat{i}_1$, is given by the load and the operating point, not by (8). In case of a non-inductive load, such as a transformer with an $LC$ filter, the term $n\omega_1 L$ in (8) is to be replaced by an appropriate transfer function.

*Objective function*

OPPs are typically computed with the aim to minimize the harmonic distortions in the load current. To this end, the total demand distortion (TDD) of the current

$$I_{TDD} = \frac{1}{\sqrt{2}I_R} \sqrt{\sum_{n \neq 1} (\hat{i}_n)^2} \qquad (9)$$

is considered, which is the square root of the sum of the squared current harmonic amplitudes $\hat{i}_n$ of order $n$. The current harmonic amplitudes are normalized with respect to the amplitude of the rated load current, with $I_R$ being the rms value of the rated load current.
Inserting (7) and (8) into (9) leads to

$$I_{TDD} = \frac{1}{\sqrt{2}I_R \omega_1 L} \frac{v_{dc}}{2} \sqrt{\sum_{n \neq 1} \left(\frac{\hat{u}_n}{n}\right)^2}. \qquad (10)$$

We interpret (10) as $I_{TDD} = c\sqrt{J}$. The constant c depends on the converter and load parameters, whereas the term

$$J = \sum_{n \neq 1} \left(\frac{\hat{u}_n}{n}\right)^2 \tag{11}$$

is a function of the amplitudes of the switching signal harmonics. Minimizing the current TDD is thus equivalent to minimizing J, which is typically chosen as the objective function of the OPP optimization problem.

In a three-phase system, the phases *b* and *c* are phase-shifted by $\frac{2\pi}{3}$ and $\frac{4\pi}{3}$ with respect to phase *a*. Harmonics of order *n* = 3,6,9,... are thus in phase. These *common-mode* voltage harmonics do not drive harmonic currents in a three-phase load with a floating star point. It is therefore common practice to consider only non-triple *differential-mode* harmonics in the objective function (11); these harmonics are of the order *n* = 5,7,11,13,....

*Classic optimization problem*

Traditionally, OPPs have been computed such that they meet the following requirements:

- The harmonic current distortions are minimized with the assumption of a purely inductive load (with an optional voltage source).
- The amplitude of the fundamental component of the switching signal, $\hat{u}_1$, is equal to the desired modulation index *m*.
- The fundamental component has zero phase.
- The switching angles are in an ascending order; in combination with (2), this ensures that the switch positions are limited to $u_i \in \{-1,0,1\}$ for $i \in \{0,1, ... ,4d\}$, i.e., for the whole fundamental period.

For OPPs with QaHWS, this leads to the optimization problem

$$\underset{\alpha_i}{\text{minimize}} \quad \frac{16}{\pi^2} \sum_{n=5,7,11,...} \frac{1}{n^4} \left(\sum_{i=1}^{d} \Delta u_i \cos(n\alpha_i)\right)^2 \tag{12a}$$

$$\text{subject to} \quad \frac{4}{\pi} \sum_{i=1}^{d} \Delta u_i \cos(\alpha_i) = m \tag{12b}$$

$$0 \leq \alpha_1 \leq \alpha_2 \leq \cdots \leq \alpha_d \leq \frac{\pi}{2}, \tag{12c}$$

where we have inserted (5) into (6) and (11) to derive the objective function (12a). The constant term $16/\pi^2$ is typically neglected and removed from (12a).

For OPPs with HWS the optimization problem is

$$\underset{\alpha_i}{\text{minimize}} \quad \frac{4}{\pi^2} \sum_{n=5,7,11,...} \frac{1}{n^4} \left(\sum_{i=1}^{2d} \Delta u_i \sin(n\alpha_i)\right)^2 + \left(\sum_{i=1}^{2d} \Delta u_i \cos(n\alpha_i)\right)^2 \tag{13a}$$

$$\text{subject to} \quad \frac{2}{\pi} \sum_{i=1}^{2d} \Delta u_i \cos(\alpha_i) = m \qquad (13b)$$

$$-\frac{2}{\pi} \sum_{i=1}^{2d} \Delta u_i \sin(\alpha_i) = 0 \qquad (13c)$$

$$0 \leq \alpha_1 \leq \alpha_2 \leq \cdots \leq \alpha_{2d} \leq \pi. \qquad (13d)$$

As before the constant term $4/\pi^2$ is typically ignored in (13a). The constraint (13c) ensures that the phase of the fundamental component is zero.

PROPOSED METHOD

To maximize the capability of the electrical converter 18, to ensure operation of the semiconductor devices within their safe operating area and to increase the output current of the converter 18 close to its physical limits, the optimization problem described above is supplemented with constraints as described in the following.

The method for computing the optimized pulse patterns 20 may be performed by the computing device 14 optionally together with the controller 16.

In general, the switching angles $\alpha_i$ of an optimized pulse pattern are computed by minimizing a total demand distortion of a load current produced by the optimized pulse pattern 20, wherein an objective function is minimized, which models the total demand distortion of a load current in dependence of the switching angles $\alpha_i$ and switch positions $u_i$. Such objective functions are provided with (12a), (13a) above.

This optimization problem is subject to the constraints, which ensure that the order of the switch positions is kept and such that the desired modulation index is reached.

The total demand distortion of the load current is minimized subject to the constraint that the order of the switching transitions is fixed. See (12c) and (13d) above.

The total demand distortion of the load current is minimized subject to the constraint that an amplitude of a fundamental component $\hat{u}_1$ of the load current is equal to a modulation index $m$. See (12b) and (13b) above.

Additionally to these constraints, the total demand distortion of the load current is minimized subject to further constraints, which limit at least one quantity, which ensures an operation of a set of semiconductor devices 26 of the electrical converter 18 within their safe operating area. The set of semiconductor devices 26 may be all power semiconductor devices of the electrical converter 18, the semiconductor switches, specific subsets of the semiconductor switches, etc.

The quantity which ensures an operation of a set of semiconductor devices may be a turn-off current, a switching loss, a temperature and/or a voltage to be blocked. The corresponding constraints will be described in detail in the following.

In general, the quantity depends on the switching angles $\alpha_i$ and the switch positions $u_i$ and the constraint enters the optimization problem in the form of an inequality.

It has to be noted that at least some of the constraints for the quantity are present for each semiconductor device 26 from the set of semiconductor devices, i.e. there may be device specific constraints.

Additionally, the quantity may depends on a displacement angle $\phi$, which is the phase of a fundamental component of the load current with respect to a fundamental voltage component of an output voltage produced by the optimized pulse pattern 20, and the constraints are imposed with respect to a set $\Phi$ of relevant displacement angles. This will be described in detail with respect to each type of quantity below.

For example, the set of relevant displacement angles may be $\Phi = \{-30°, -20°, ..., 30°\}$. However, also other sets may be possible.

*Turn-off current*

The phase current depends on the load impedance as well as on the amplitude and phase of the (fundamental) current component. The latter, the phase of the fundamental current with respect to the fundamental voltage component, is the so-called displacement angle $\phi$. An equation for the instantaneous phase current is derived below.

Since an inductive load is assumed, it is sufficient to constrain the phase current at the switching transitions to upper bound the peak current. The switching transitions occur at the switching angles of phase *a, b* and *c*. Having assumed HWS for the single-phase switching pattern, see Sect. I-A, the set of switching angles over a fundamental period in phases *a* is given by

$$A_a = \{\alpha_1, \alpha_2, \dots, \alpha_{2d}, \pi + \alpha_1, \pi + a_2, \dots, \pi + \alpha_{2d}\}. \qquad (14)$$

The switching angles in phases *b* and *c* are phase-shifted by $2\pi/3$ and $4\pi/3$, respectively. This leads to the sets of switching angles in phase *b* and *c*

$$A_b = \mathrm{mod}\left(A_a + \frac{2\pi}{3}, 2\pi\right) \text{and } A_c = \mathrm{mod}\left(A_a + \frac{4\pi}{3}, 2\pi\right),$$

where $\mathrm{mod}(\theta, 2\pi)$ denotes the modulo operation and yields the least positive remainder when dividing the argument by an integer times $2\pi$. As a result, the switching angles in the three sets are bounded between 0 and $2\pi$. The set of three-phase switching angles is the union of the single-phase sets, i.e.,

$$A_{abc} = A_a \cup A_b \cup A_c.$$

Consider the phase current $i(\theta, \phi)$ with the argument $\theta$ and the displacement angle $\phi$. The peak current can then be limited by the set of constraints

$$|i(\theta, \phi)| \leq i_{lim}, \quad \forall \theta \in A_{abc}, \phi \in \Phi, \qquad (15)$$

which are added to the OPP optimization problem. These current limiting constraints constrain that a peak current $i(\theta, \phi)$ produced by the optimized pulse pattern at each switching transition is smaller than a limiting current $i_{lim}$.

Because the peak current depends on the displacement angle $\phi$, constraints are imposed for several displacement angles, where $\Phi$ is the set of displacement angles relevant for converter operation.

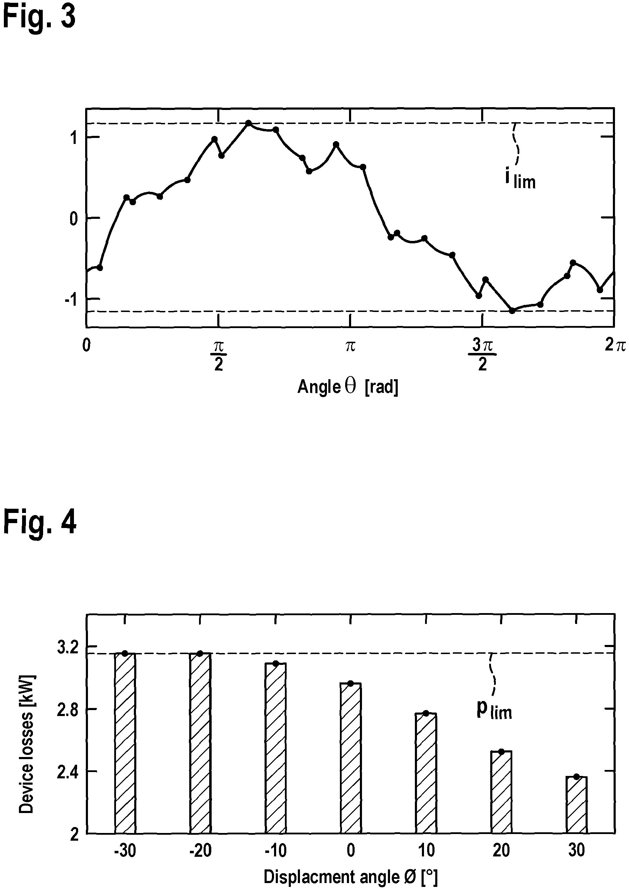

An example of a constrained phase current is shown in Fig. 3, where $i_{lim}$ = 1.15 pu.

*Semiconductor losses*

Below equations will be derived that describe the evolution of the (instantaneous) switching and conduction losses for a given optimized pulse pattern. To do so, the specific semiconductor loss parameters may be taken from the semiconductor data sheet. Moreover, the losses depend on the fundamental frequency, the amplitude of the fundamental current component and the displacement angle.

For the switching losses, an equation for the commutated current of each semiconductor device is derived. The switching energy losses can then be calculated at each to-be-computed switching transition. In the case of the conduction losses, an equation for the current through each semiconductor device is derived.

This leads to the switching and conduction losses of the *j*th semiconductor device, $p_{sw}^j$ and $p_{cond}^j$, where $p_{sw}^j$ and $p_{cond}^j$ can be the average or peak losses. In case of an NPC converter, each phase uses four GCTs, four freewheeling diodes and two clamp diodes, see Fig. 6, so we have *j* = 1,2,...,10. The numbering of the semiconductors is also explained with respect to Fig. 6.

Constraints on the semiconductor losses can then be added to the OPP optimization problem, which allows us to calculate OPPs with a guaranteed upper bound on the semiconductor losses. We can either limit the (total) semiconductor losses in one phase leg using a constraint of the form

$$\sum_{j=1}^{10} (p_{sw}^j(\phi) + p_{cond}^j(\phi)) \leq p_{tot,lim}, \quad \phi \in \Phi, \qquad (16)$$

or we limit the semiconductor losses of each device using several constraints of the form

$$p_{sw}^{j}(\phi) + p_{cond}^{j}(\phi) \leq p_{lim}^{j}, \quad \forall_{j} \in \{1, 2, \dots, 10\}, \phi \in \Phi \qquad (17)$$

In both cases, the losses over one fundamental period and in one phase leg are constrained. As mentioned above, the losses depend on the displacement angle $\phi$, and constraints may be imposed for the set of relevant displacement angles $\Phi$.

To the optimization problem, loss constraints (16, 17) may be added, which constrain that the semiconductor losses $p_{sw}^{j}$ and/or $p_{cond}^{j}$ are smaller than limiting losses $p_{tot,lim}$ and/or $p_{lim}^{j}$. A semiconductor loss $p_{sw}^{j} + p_{cond}^{j}$ may be determined for each semiconductor device 26, here numbered by $j$, from the set of semiconductor devices. The semiconductor loss of a semiconductor device 26 may be the sum of a switching loss $p_{sw}^{j}$, and a conduction loss and $p_{cond}^{j}$ of the semiconductor device 26.

It is possible that a loss constraint is present constraining that the sum of semiconductor losses of the set of semiconductor devices is smaller than an overall limiting loss, see (16). By limiting the sum of the semiconductor losses, see (16), the converter efficiency is improved.

It is also possible that for each semiconductor device 26 of the set of semiconductor devices, a loss constraint is present that the semiconductor loss of the semiconductor device is smaller than a limiting loss for the semiconductor device, see (17). By limiting the losses of each individual semiconductor, see (17), the worst case losses are reduced and, as a consequence, the worst case junction temperature tends to be reduced as well.

However, it may be that the inequality constraints reduce the search space of the optimization problem. As a result, the current distortions tend to (slightly) increase when imposing limits on the semiconductor losses.

An example of a constraint on the semiconductor losses (for GCT 1) is shown in Fig. 4, where $p_{lim}$ = 3.15 kW and the set of displacement angles is $\Phi$ = {-30°, -20°, ..., 30°}.

*Junction temperature*

Building upon the equations for the semiconductor losses, a thermal model is derived below that maps the (instantaneous) semiconductor losses to an (instantaneous) semiconductor junction temperature. The junction temperature of the $j$th semiconductor is given by

$$T_{j}^{j} = T_{j-w}^{j} + T_{w}, \qquad (18)$$

where $T_{j-w}^{j}$ denotes the junction-to-water temperature drop of the $j$th semiconductor and $T_{w}$ is the cooling water temperature at the inlet of the cooling element that extracts the heat from the semiconductor by means of a water cooling circuit. In case of air-cooled semiconductors, (18) is to be replaced by $T_{j}^{j} = T_{j-w}^{j} + T_{a}$, where $T_{a}$ denotes the ambient air temperature around the cooling element. The water temperature $T_{w}$ can be considered as a design parameter.

The quantity of concern is the semiconductor junction temperature. We may impose limits either on the average, the ripple, and/or the instantaneous semiconductor temperatures. To this end, we define

$$T_{j-w}^{j} = T_{j-w,avg}^{j} + T_{j-w,rip}^{j},$$

allowing us to consider the average temperature as well as the temperature ripple of the $j$th semiconductor. With this definition, we can limit the average junction temperature of the $j$th semiconductor with the constraint

$$T^j_{j-w,avg}(\phi) + T_w \leq T^j_{avg,lim}, \quad \forall_j \in \{1,2,\dots,10\}, \phi \in \Phi, \qquad (19)$$

which is added to the OPP optimization problem. The temperature limiting constraints (19) constrain that average temperatures $T^j_{j-w,avg}$ of a semiconductor device 26 optionally in sum with a cooling medium temperature $T_w$ are smaller than limiting temperatures $T^j_{avg,lim}$ for the semiconductor device 26.

Additionally and/or alternatively, the ripple and the peak (instantaneous) junction temperature can be constrained with

$$T^j_{j-w,rip}(\theta,\phi) \leq T^j_{rip,lim}, \quad \forall_j \in \{1,2,\dots,10\}, \theta \in A_a, \phi \in \Phi, \qquad (20)$$

$$T^j_{j-w}(\theta,\phi) + T_w \leq T^j_{lim}, \quad \forall_j \in \{1,2,\dots,10\}, \theta \in A_a, \phi \in \Phi, \qquad (21)$$

respectively. As previously, $A_a$ is the set of single-phase switching angles over a fundamental period.

Temperature limiting constraints (20) and/or (21) may be added to the OPP optimization problem, which constrain that a ripple and/or peak junction temperature for each semiconductor device 26 of the set of semiconductor devices is smaller than a corresponding limiting temperature $T^j_{rip,lim}$ and/or $T^j_{lim}$.

It has to be noted that for each semiconductor device 26, which are numbered by $j$ here, of the set of semiconductors, at least one temperature constraint may be present.

Further note that, due to the high switching losses of medium-voltage converters, it is highly likely that the peak of the ripple and the instantaneous temperatures will occur at a switching transition.

As previously, $\Phi$ is the set of relevant displacement angles. An example of a constrained junction temperature (for GCT 1) is shown in Fig. 5, where $T_{lim}$ = 125°C and $T_w$ = 37°C.

*Blocking voltage*

To limit the blocking voltage, the peak value of the half dc-link voltage ripple of the NPC converter may be limited. Alternatively or additionally, the neutral-point ripple may also be limited to (indirectly) limit the blocking voltage. These quantities depend on the dc-link capacitance, fundamental frequency, amplitude of the (fundamental) current component and displacement angle.

Denote with

$$v_{dc} = v_{dc,lo} + v_{dc,up} \qquad (22)$$

$$v_{np} = \frac{1}{2}(v_{dc,lo} - v_{dc,up}) \qquad (23)$$

the total dc-link voltage and the neutral-point potential, respectively. The voltage ripple in the lower and upper dc-link halves is

$$v_{dc,lo,rip} = \frac{v_{dc,rip}}{2} + v_{np} \qquad (24a)$$

$$v_{dc,up,rip} = \frac{v_{dc,rip}}{2} - v_{np} , \qquad (24b)$$

where $v_{dc,rip}$ denotes the ripple of the total dc-link voltage $v_{dc}$.

Due to the symmetry, it is sufficient to consider either $v_{dc,up,rip}$ or $v_{dc,lo,rip}$. $v_{np}$ and $v_{dc,rip}$ are linear in the switching transition $\Delta u_i$, but nonlinear in the switching angles $\alpha_i$ and displacement angle $\phi$ (specifically, they are arguments of sine and cosine terms).

We introduce the set of angles $\Theta_v$, which includes the switching angles and possibly additional angles at which the peak value of the neutral-point potential or half dc-link voltages could occur. The peak neutral-point potential can be limited using

$$\left| v_{np}(\theta, \phi) \right| \leq v_{np,lim}, \qquad \forall \theta \in \Theta_v, \phi \in \Phi, \qquad (25)$$

A neutral-point potential constraint may be added to the optimization problem, which constrains that a neutral-point potential $v_{np}$ is smaller than a limiting neutral-point voltage $v_{np,lim}$.

The half dc-link ripple can similarly be limited using

$$\left| v_{dc,up,rip}(\theta, \phi) \right| \leq v_{dc,up,rip,lim}, \qquad \forall \theta \in \Theta_v, \phi \in \Phi. \qquad (26)$$

A dc-link ripple constraint may be added to the optimization problem, which constrains that a dc-link ripple $v_{dc,up,rip}$ is smaller than a limiting dc-link ripple voltage $v_{dc,up,rip,lim}$.

The models that describe the phase current, semiconductor losses, junction temperatures and blocking voltages are functions of the to-be-computed switching angles. Importantly, these models are described by algebraic functions that have closed-form expressions for their derivatives. This allows us to add the above quantities to the OPP optimization problem in the form of inequality constraints and, thanks to the derivatives, efficiently solve the optimization problem to derive the optimal sets of switching angles.

LIMITING THE PEAK TURN-OFF CURRENT

In this section, it is shown in more detail how the peak current can be limited. Due to three-phase symmetry, only a single-phase current needs to be considered.

*Current model*

Using superposition, the instantaneous output phase current

$$i(\theta, \phi) = i_1(\theta, \phi) + i_{rip}(\theta), \qquad (27)$$

is the sum of the fundamental current

$$i_1(\theta, \phi) = \sqrt{2}I\sin(\theta + \phi) \qquad (28)$$

and the harmonic (ripple) current

$$i_{rip}(\theta) = \sum_{n=5,7,11,\dots} \left( a_{i,n} \cos(n\theta) + b_{i,n} \sin(n\theta) \right), \qquad (29)$$

where $a_{i,n}$ and $b_{i,n}$ are the Fourier coefficients of the harmonic current. To derive these coefficients, we write the Fourier series (3) of the switching signal in exponential form with the Fourier coefficients

$$c_n = \frac{1}{2}(a_n - \mathrm{i}b_n),$$

where $\mathrm{i} = \sqrt{-1}$ is the imaginary unit. By multiplying the Fourier coefficients with half the dc-link voltage, see (7), and by dividing them by the complex-valued load impedance similar to (8), we obtain the complex-valued Fourier coefficient of the harmonic current

$$c_{i,n} = \frac{v_{dc}}{2}\frac{c_n}{\mathrm{i}n\omega_1 L} = \frac{v_{dc}}{2}\frac{1}{2}\frac{a_n - \mathrm{i}b_n}{\mathrm{i}n\omega_1 L} = \frac{v_{dc}}{2\omega_1 L}\frac{1}{2}\frac{(-b_n - \mathrm{i}a_n)}{n}.$$

Thus, the Fourier coefficients of (29) are

$$a_{i,n} = -\frac{v_{dc}}{2\omega_1 L}\frac{b_n}{n} \qquad\qquad (30a)$$

$$b_{i,n} = -\frac{v_{dc}}{2\omega_1 L}\frac{a_n}{n}. \qquad\qquad (30b)$$

Because the current through a semiconductor device is equal to the phase current, limiting the peak phase current limits the peak device current.

*Constraint on the peak current*

Recall the set $A_{abc}$ that contains the three-phase switching angles over a fundamental period; for an inductive load, the peak current occurs at a switching transition. The set of all possible displacement angles are denoted by $\Phi$. The constraints for the peak current can then formally be defined as

$$|i(\theta, \phi)| \leq i_{lim}, \quad \forall \theta \in A_{abc}, \phi \in \Phi. \qquad\qquad (31)$$

LIMITING THE SEMICONDUCTOR POWER LOSSES

In this section, it is shown in more detail how the losses of a semiconductor device can be upper bounded. Consider a pulse pattern with 4d switching transitions over a fundamental period, which can be described for $0 \leq \theta \leq 2\pi$ as

$$u(\theta) = \sum_{i=1}^{4d} \Delta u_i h(\theta - \alpha_i), \qquad\qquad (32)$$

where h is the unit step function. Note that the initial switch position $u_0$ is zero, but no symmetry is assumed in a single phase. A non-zero initial switch position can be considered by defining

$$u(\theta) = u_0 + \sum_{i=1}^{4d} \Delta u_i h(\theta - \alpha_i) = \sum_{i=0}^{4d} \Delta u_i h(\theta - \alpha_i),$$

where $\Delta u_0 = u_0$ and $\alpha_0 = 0$ have been introduced. However, three-phase symmetry is assumed, meaning that it is sufficient to only consider a single phase.

The losses of a semiconductor can be categorized into switching losses, which are due to the non-instantaneous on and off transitions times, and conduction losses, which result from the on-state resistance of the devices. Each of these losses is modelled in a different way, which will be discussed in the following.

Fig. 6 shows the conduction paths for positive phase current depending on the switching state, as well as the indices that are used when referring to a device. The current paths for negative phase current can similarly be derived.

*Switching losses*

For the GCTs, the turn-on and turn-off losses linearly depend on the anode-cathode voltage $v_T$ and the anode current $i_T$. In an NPC converter, the anode-cathode voltage is approximately equal to the half dc-link voltage, and the anode current is equal to the phase current.

*1) Switching energy losses:* With the device specific coefficients $c_{on}$ and $c_{off}$, the turn-on and turn-off switching energy losses are given by

$$e_{on} = c_{on} \frac{1}{2} v_{dc} i_T \qquad (33a)$$

$$e_{off} = c_{off} \frac{1}{2} v_{dc} i_T, \qquad (33b)$$

respectively. Here, the assumption is used that $v_T \approx v_{dc}/2$. Alternatively, to increase the precision of the loss computation, $v_T$ could be chosen as either $v_{dc,lo}$ depending on whether the device is located in the upper or the lower half of the converter. Note that the anode current $i_T$ is, by definition, always positive. For the GCT, $c_{on}$ is typically much smaller than $C_{off}$.

The turn-on losses of the power diode are effectively zero. Therefore, only the turn-off losses-the so-called reverse-recovery losses of a diode-are considered. The reverse-recovery losses are linear in the voltage but nonlinear in the current, with the reverse-recovery energy losses being

$$e_{rr} = c_{rr} \frac{1}{2} v_{dc} f_{rr}(i_T) \qquad (34)$$

where the coefficient $c_{rr}$ lies typically in the interval of $c_{on}$ and $c_{off}$. The nonlinear function $f_{rr}$ is typically concave and goes from 0 to 1. In Table 1, the switching losses per device are shown.

To determine for each switching transition the switching energy losses each device carries, the polarity of the phase current and the switching transition are required. The latter can be easily determined from the single-phase switching pattern $u(\theta)$. But determining the former, the phase current polarity, is challenging when considering the switching ripple on the phase current, which affects its polarity.

TABLE 1: Switching energy losses

| Polarity of the current | Switching transition | Switching energy losses |
|---|---|---|
| > 0 | $0 \rightarrow 1$ | $e_{on}^1 + e_{rr}^9$ |
| | $1 \rightarrow 0$ | $e_{off}^1$ |
| | $0 \rightarrow -1$ | $e_{off}^2$ |
| | $-1 \rightarrow 0$ | $e_{on}^2 + e_{rr}^8$ |

(continued)

| Polarity of the current | Switching transition | Switching energy losses |
|---|---|---|
| < 0 | 0 → 1 | $e_{off}^3$ |
| | 1 → 0 | $e_{on}^3 + e_{rr}^5$ |
| | 0 → -1 | $e_{on}^4 + e_{rr}^{10}$ |
| | -1 → 0 | $e_{off}^4$ |

*2) Phase current decomposition:* To determine the polarity of the phase current and in order to determine which device carries switching losses, we propose to decompose the phase current into its positive and negative components. An extractor function is thus required that satisfies g(i) ≈ 1 for phase currents with $i \geq 0$ and g(i) ≈ 0 for $i < 0$. A suitable function for this is a (shifted) hyberbolic tangent function:

$$g(i) = \frac{1}{2} + \frac{1}{2}\tanh(\lambda i),\qquad(35)$$

where $\lambda > 0$ is a tuning factor. Using (35), the positive current and the negative current (but with flipped polarity) can be extracted using

$$i_p(\theta,\phi) = i(\theta,\phi)g\big(i(\theta,\phi)\big)\qquad(36a)$$

$$i_n(\theta,\phi) = i(\theta,\phi)g\big(i(\theta,\phi)\big) - 1),\qquad(36b)$$

respectively. These currents are, by definition, always non-negative. In particular, their sum is equal to the absolute value of the phase current, i.e., $|i(\theta,\phi)| = i_p(\theta,\phi) + i_n(\theta,\phi)$ holds.

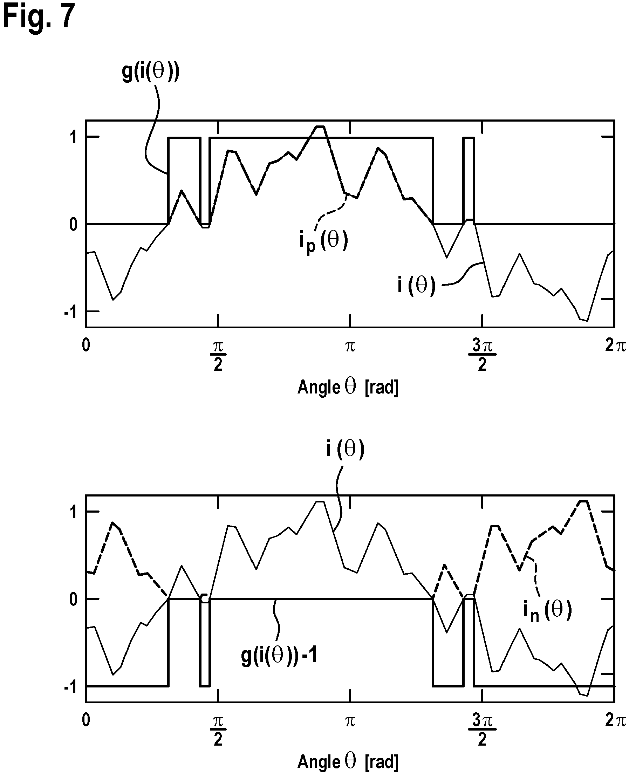

In Fig. 7, an example of the positive and negative phase current is shown. Note that the ripple is artificially increased so that the current changes its polarity more than once within a half-fundamental period.

*3) Instantaneous switching power losses:* Consider a turn-on switching energy loss of a GCT as defined in (33a). It is well-known that the time-derivative of the energy losses are the power losses, i.e.,

$$p_{on}(t) = \frac{de_{on}(t)}{dt}.\qquad(37)$$

With the substitution $t = \theta/\omega_1$, the power losses can be rewritten as a function of the angle $\theta$

$$p_{on}(\theta) = \omega_1 \frac{de_{on}(\theta)}{d\theta}.\qquad(38)$$

The power from a switching event is dissipated within a fraction of a microsecond and, thus, instantaneously. This allows us to use impulses to model the switching power losses. For the *j*th switching transition, we write

$$p_{on,j}(\theta,\phi) = \omega_1 c_{on} \frac{v_{dc}}{2} i_T(\theta,\phi)\delta\big(\theta - \theta_j\big),\qquad(39)$$

where $\delta$ is the well-known impulse function and $\theta_j$ is the *j*th switching angle. The impulses are placed at the switching angles where the current is commutated. It can easily be verified that

$$e_{on,j}(\theta_j, \phi) = \frac{1}{\omega_1} \int_0^\infty \omega_1 c_{on} \frac{v_{dc}}{2} i_T(\theta, \phi) \delta(\theta - \theta_j) d\theta = c_{on} \frac{v_{dc}}{2} i_T(\theta_j, \phi);$$

in other words, the strength of an impulse at the switching instant is equal to the switching energy loss.

It follows from Table 1 that for GCTs 1 and 2, and diodes 8 and 9, the (commutated) anode current $i_T$ is equal to $i_p$; for GCTs 3 and 4, and diodes 5 and 10, the anode current is equal to $i_n$.

Similarly, for the turn-off and reverse-recovery losses, the switching (power) losses are derived as

$$p_{off,k}(\theta, \phi) = \omega_1 c_{off} \frac{v_{dc}}{2} i_T(\theta, \phi) \delta(\theta - \theta_k) \qquad (40)$$

$$p_{rr,\ell}(\theta, \phi) = \omega_1 c_{rr} \frac{v_{dc}}{2} f_{rr}(i_T(\theta, \phi)) \delta(\theta - \theta_\ell). \qquad (41)$$

We introduce the switching energy loss coefficient of the ith switching transition, $c_i$, which is either zero or captures turn-on, turn-off, or reverse-recovery losses, i.e., $c_i \in \{0, c_{on}, c_{off}, c_{rr}\}$. We also define the vector $c = [c_1 \ c_2 \ ... \ c_{4d}]^\mathsf{T}$, where $4d$ is the (maximum number) of switching transitions per period. Without loss of generality, by assuming a half-wave symmetry pulse pattern with only positive switch positions during the first half, it follows from Table I that

$$c^T = \begin{cases} \left[c_{on} \ c_{off} \ c_{on} \ ... \ c_{off} \ \mathbf{0}_{2d}^T\right] & \text{for GCT 1,} \\ \left[\mathbf{0}_{2d}^T \ c_{off} \ c_{on} \ c_{off} \ ... \ c_{on}\right] & \text{for GCT 2,} \\ \left[c_{off} \ c_{on} \ c_{off} \ ... \ c_{on} \ \mathbf{0}_{2d}^T\right] & \text{for GCT 3,} \\ \left[\mathbf{0}_{2d}^T \ c_{on} \ c_{off} \ c_{on} \ ... \ c_{off}\right] & \text{for GCT 4,} \\ \left[0 \ c_{rr} \ 0 \ ... \ c_{rr} \ \mathbf{0}_{2d}^T\right] & \text{for Diode 5,} \\ \left[\mathbf{0}_{2d}^T \ 0 \ c_{rr} \ 0 \ ... \ c_{rr}\right] & \text{for Diode 8,} \\ \left[c_{rr} \ 0 \ c_{rr} \ ... \ 0 \ \mathbf{0}_{2d}^T\right] & \text{for Diode 9,} \\ \left[\mathbf{0}_{2d}^T \ c_{rr} \ 0 \ c_{rr} \ ... \ 0\right] & \text{for Diode 10.} \end{cases}$$

The vector $\mathbf{0}_{2d}$ is a zero column vector of dimension $2d$. We also define the current $f$, which is either $i_p$, $i_n$, $f_{rr}(i_p)$, or $f_{rr}(i_n)$. Specifically, according to Table I, $f$ is defined as

$$f = \begin{cases} i_p & \text{for GCT 1 or GCT 2,} \\ i_n & \text{for GCT 3 or GCT 4,} \\ f_{rr}(i_p) & \text{for Diode 8 or Diode 9,} \\ f_{rr}(i_n) & \text{for Diode 5 or Diode 10.} \end{cases}$$

In case of the GCTs, the function f represents the anode current $i_T$, whereas the diodes f represent $f_{rr}(i_T)$.

With these two definitions, we can state the switching losses of a device over a fundamental period as

$$p_{sw}(\theta, \phi) = \omega_1 \frac{v_{dc}}{2} \sum_{i=1}^{4d} c_i f(\theta, \phi) \delta(\theta - \alpha_i). \qquad (42)$$

We illustrate this concept with an example. The top GCT (device 1 in Fig. 6) operated with the pulse pattern shown in Fig. 2 (with pulse number $d = 2$) conducts positive phase current and carries switching losses only during the positive half-wave, i.e., for $0 \leq \theta \leq \pi$. Thus, $f = i_p$ and c = $[c_{on} \ c_{off} \ c_{on} \ c_{off} \ 0 \ 0 \ 0 \ 0]^\mathsf{T}$.

*4) Average switching losses:* The average of a quantity x is

$$x_{avg} = \frac{1}{2\pi}\int_0^{2\pi} x(\theta)d\theta. \tag{43}$$

With this, the average of the switching losses (42) over a period is

$$p_{sw,avg}(\phi) = \omega_1 \frac{v_{dc}}{4\pi}\sum_{i=1}^{4d} c_i f(\alpha_1, \phi). \tag{44}$$

*Conduction losses*

The (instantaneous) conduction losses for both a GCT and a diode have an identical form, and can be modelled as

$$p_{cond}(\theta, \phi) = V_{on}i_T(\theta, \phi) + R_{on}\big(i_T(\theta, \phi)\big)^2. \tag{45}$$

More accurate models can be obtained, but (45) is usually sufficient. The parameters $V_{on}$ and $R_{on}$ are device specific. For the derivation of the conduction losses, a purely sinusoidal phase current of the form

$$i(\theta, \phi) = \sqrt{2}I\sin(\theta + \phi) \tag{46}$$

is assumed. By neglecting the current ripple, we avoid integrals that do not have closed-form solutions.

TABLE II: Conduction power losses

| Polarity of the current | Switch position | Conduction power losses |
|---|---|---|
| > 0 | 1 | $p_{cond}^1 + p_{cond}^2$ |
| | 0 | $p_{cond}^2 + p_{cond}^9$ |
| | - 1 | $p_{cond}^7 + p_{cond}^8$ |
| < 0 | 1 | $p_{cond}^5 + p_{cond}^6$ |
| | 0 | $p_{cond}^3 + p_{cond}^{10}$ |
| | - 1 | $p_{cond}^3 + p_{cond}^4$ |

*1) Phase current decomposition:* Before continuing, and as with the switching losses, the phase current needs to be decomposed into its positive and negative components. The hyperbolic extractor function (35) cannot be used here, because it would result for the conduction losses in integrals that do not have an elementary antiderivative. Instead, we define the step-based extractor function

$$g(\theta) = g_0 + \Delta g_1 h(\theta + \phi_1) + \Delta g_2 h(\theta + \phi_2), \tag{47}$$

where $g_0 \in \{0,1\}$ is the initial extractor position, $\Delta g_i \in \{-1,1\}$ is the ith extractor transition, and $\phi_i$ is the ith extractor transition angle. If the current is positive, we require $g = 1$; otherwise, we require $g = 0$. For a given displacement angle $\phi$, the parameters of (47) can easily be determined. Note that

$$g(\theta) - 1 = (g_0 - 1) + \Delta g_1 h(\theta + \phi_1) + \Delta g_2 h(\theta + \phi_2)$$

extracts the negative current and flips its polarity. The positive and the (flipped) negative current can be described as

$$i_p(\theta, \phi) = i(\theta, \phi)g(\theta) \qquad (48a)$$

$$i_n(\theta, \phi) = i(\theta, \phi)g(\theta) - 1, \qquad (48b)$$

respectively. These currents are, as previously, always non-negative, and their sum is equal to the absolute value of the phase current, i.e., $|(i(\theta,\phi)| = i_p(\theta,\phi) + i_n(\theta,\phi)$ holds.

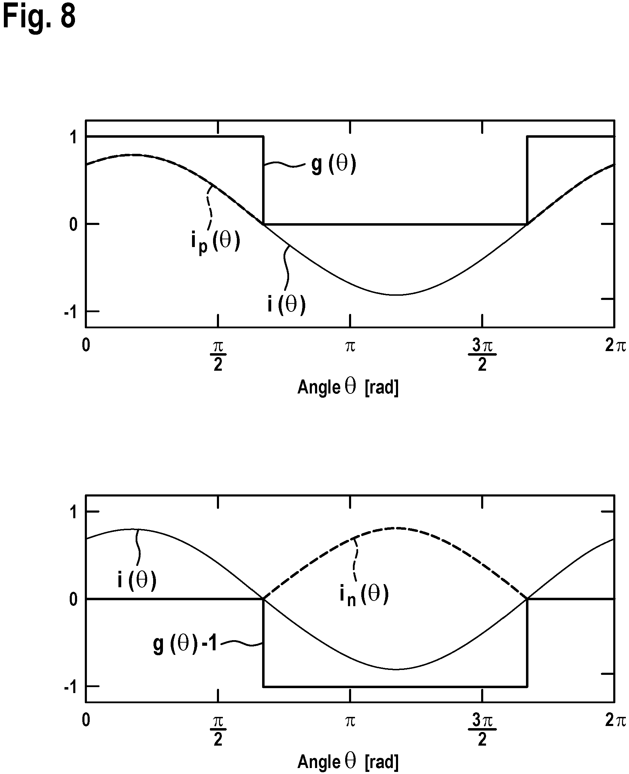

Fig. 8 illustrates the extractor function. Note that the extraction transitions angles are set equal to the zero crossing angles of the phase currents. In the figure, in which $-\pi \le \phi \le 0$ holds, the extraction transitions angles are set to $\phi_1 = \pi - \phi$ and $\phi_2 = 2\pi - \phi$. Equation (48) can be expanded to the second power of the current as

$$\left(i_p(\theta, \phi)\right)^2 = \left(i(\theta, \phi)\right)^2 g(\theta)$$

$$\left(i_n(\theta, \phi)\right)^2 = -(i(\theta, \phi))^2 (g(\theta = -1).$$

*2) Instantaneous conduction losses:* By inspecting how a given pulse pattern switches a device, the switching state of any device can be described as

$$s(\theta) = \sum_{i=0}^{4d} \Delta s_i h(\theta - \alpha_i), \qquad (50)$$

where $s \in \{0,1\}$. If $s = 1$, the device conducts; likewise, if $s = 0$, the device is in the blocking state. Note that the sum in (50) starts with the index $i = 0$, with the dummy switching angle and switching state transition defined as $\alpha_0 = 0$ and $\Delta s_0 = s_0$, respectively. The switching state transitions $\Delta s_i \in \{-1,0,1\}$ are a function of the specific device and the switching pattern. Let $\Delta \boldsymbol{s} = [s_0 \, \Delta s_1 \, \Delta s_2 \, ... \, \Delta s_{4d}]^{\mathsf{T}}$ denote the vector of switching transitions. Without loss of generality, by assuming a half-wave symmetry pulse pattern with only positive switch positions during the first half of the fundamental period, $\Delta \boldsymbol{s}$ is defined for each device as

$$\Delta \boldsymbol{s}^T = \begin{cases} [0\ 1 - 1\ 1 \ldots - 1\ \boldsymbol{0}_{2d}^T] & \text{for GCT 1 or Diode 5 or Diode 6,} \\ [1\ \boldsymbol{0}_{2d}^T - 1\ 1 - 1 \ldots 1] & \text{for GCT 2,} \\ [1 - 1\ 1 - 1 \ldots 1\ \boldsymbol{0}_{2d}^T] & \text{for GCT 3,} \\ [0\ \boldsymbol{0}_{2d}^T\ 1 - 1\ 1 \ldots - 1] & \text{for GCT 4 or Diode 7 or Diode 8,} \\ [1 - 1\ 1 - 1 \ldots 1] & \text{for Diode 9 or Diode 10.} \end{cases} \qquad (51)$$

With this, according to Table II, the anode current can be expressed as

$$i_T(\theta, \phi) = s(\theta) \begin{Bmatrix} i_p(\theta, \phi) \text{ for GCTs } 1, 2 \text{ or Diodes } 7, 8 \text{ or } 9, \\ i_n(\theta, \phi) \text{ for GCTs } 3, 4 \text{ or Diodes } 5, 6 \text{ or } 10 \end{Bmatrix} \qquad (52)$$

$$= s(\theta) \begin{Bmatrix} g(\theta, \phi), \\ g(\theta, \phi) - 1 \end{Bmatrix} i(\theta, \phi),$$

where we have used (48). Using (47), we simplify this expression by defining the variable

$$r(\theta) = \bar{g}_0 + \Delta g_1 h(\theta + \phi_1) + \Delta g_2 h(\theta + \phi_2)$$

with

$$\bar{g}_0 = \begin{cases} g_0 & \text{for GCTs } 1, 2 \text{ or Diodes } 7, 8 \text{ or } 9, \\ g_0 - 1 & \text{for GCTs } 3, 4 \text{ or Diodes } 5, 6 \text{ or } 10. \end{cases} \qquad (53)$$

This simplifies (52) to

$$i_T(\theta, \phi) = s(\theta) r(\theta) i(\theta, \phi). \qquad (54)$$

Similarly, we define the squared anode current as

$$\left(i_T(\theta, \phi)\right)^2 = b s(\theta) r(\theta) \left(i(\theta, \phi)\right)^2, \qquad (55)$$

where we require the auxiliary variable

$$b = \begin{cases} 1 & \text{for GCTs } 1, 2 \text{ or Diodes } 7, 8 \text{ or } 9, \\ -1 & \text{for GCTs } 3, 4 \text{ or Diodes } 5, 6 \text{ or } 10, \end{cases} \qquad (56)$$

see also (49).

We can now state the anode current as a function of the switching angles, switching transitions and phase current. To this end, we insert (46) and (50) into (54) to obtain the anode current, and we insert the same equation into (55) to derive the squared anode current. This leads to

$$i_T(\theta, \phi) = \sum_{i=0}^{4d} \Delta s_i h(\theta - \alpha_i)(\bar{g}_0 + \Delta g_1 h(\theta + \phi_1) + \Delta g_2 h(\theta + \phi_2))\sqrt{2}I\sin(\theta + \phi) \qquad (57a)$$

$$(i_T(\theta, \phi))^2 = \sum_{i=0}^{4d} \Delta s_i h(\theta - \alpha_i)(\bar{g}_0 + \Delta g_1 h(\theta + \phi_1) + \Delta g_2 h(\theta + \phi_2))b2I^2\sin^2(\theta + \phi). \qquad (57b)$$

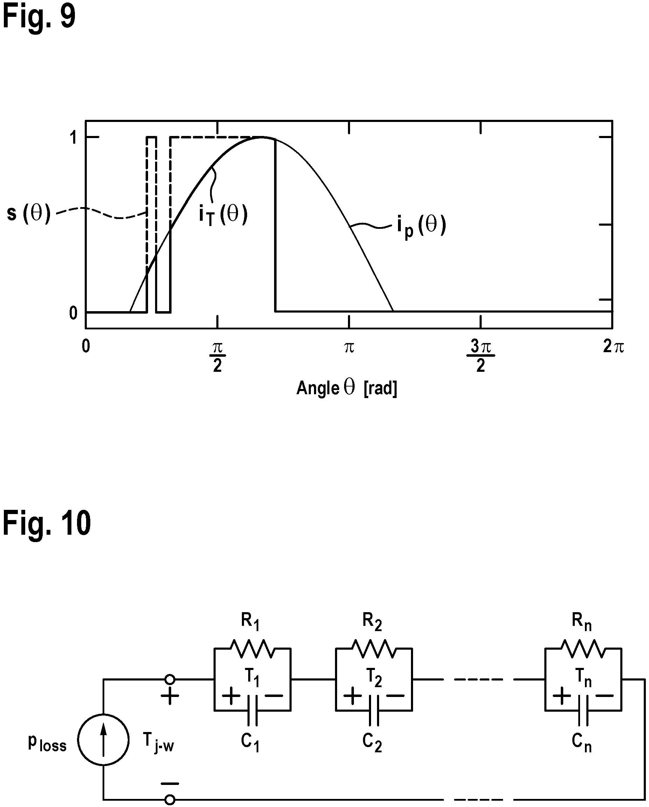

Fig. 9 illustrates the switching state and device current for GCT 1 when using the pulse pattern shown in Fig. 2. GCT 1 switches only for $0 \le \theta \le \pi$ and it conducts during the positive half-wave of the phase current. From (51) we obtain $\Delta s = [0\ 1 - 1\ 1 - 1\ 0\ 0\ 0\ 0]^T$, from (53) we read out that $\bar{g}_0 = g_0$, and (56) states that $b = 1$. We conclude that the anode current (57) is well defined with these parameters. Let

$$\boldsymbol{\alpha} = [0 \; \alpha_1 \; \alpha_2 \; ... \; \alpha_{4d}]^{\mathrm{T}}$$

denote the augmented vector of switching angles over a fundamental period. Recall that $\alpha_0 = 0$ is a dummy switching angle that we had introduced in (50). The product of two step functions at the angles $\xi$ and $\zeta$

$$h(\theta - \xi)h(\theta - \zeta) = h(\theta - \max(\xi, \zeta))$$

is a step function at the maximum of the two angles. With this we rewrite the sum in (57) as

$$\sum_{i=0}^{4d} \Delta s_i h(\theta - \alpha_i)\big(\bar{g}_0 + \Delta g_1 h(\theta + \phi_1) + \Delta g_2 h(\theta + \phi_2)\big) = \sum_{i=0}^{12d+2} \Delta \bar{s}_i h(\theta - \bar{\alpha}_i). \quad (58)$$

In here we require two definitions: The auxiliary vector of switching angles

$$\bar{\boldsymbol{\alpha}} = [\boldsymbol{\alpha}^{\mathrm{T}} \;\; \max\{\boldsymbol{\alpha}^{\mathrm{T}}, \phi_1\} \;\; \max\{\boldsymbol{\alpha}^{\mathrm{T}}, \phi_2\}]^{\mathrm{T}}$$

uses componentwise maximum operations and is of the dimension $3(4d + 1)$. The multiplier 3 results from the fact that the sum in (58) involves three products of step functions, whereas $4d + 1$ is the dimension of the augmented vector of switching angles. The auxiliary vector of switching state transitions is defined as

$$\Delta \bar{\boldsymbol{s}} = [\Delta \boldsymbol{s}^T \bar{g}_0 \;\; \Delta \boldsymbol{s}^T \Delta g_1 \;\; \Delta \boldsymbol{s}^T \Delta g_2]^{\mathrm{T}}.$$

Note that the right-hand side of (58) generalizes (50).

We insert (57) with the definition (58) into the conduction losses (45). This leads to the closed-form expression

$$p_{cond}(\theta, \phi) = \sum_{i=0}^{12d+2} \Delta \bar{s}_i h(\theta - \bar{\alpha}_i)\big(\sqrt{2}V_{on}I\sin(\theta + \phi) + b2R_{on}I^2\sin^2(\theta + \phi)\big) \quad (59)$$

for the conduction losses with angle $\theta$ and the displacement angle $\phi$ as arguments.

Equation (59) consists of products of step functions and sine (and squared sine) functions. We define the sum of step-like sine functions

$$v(\theta, \phi) = \sum_{i=0}^{12d+2} \Delta \bar{s}_i h(\theta - \bar{\alpha}_i) \sin(\theta + \phi), \quad (60)$$

and the sum of step-like squared sine functions

$$\mu(\theta, \phi) = \sum_{i=0}^{12d+2} \Delta \bar{s}_i h(\theta - \bar{\alpha}_i) \sin^2(\theta + \phi). \quad (61)$$

With this, the conduction losses (59) can be stated in the compact form

$$p_{cond}(\theta, \phi) = \sqrt{2}V_{on}Iv(\theta, \phi) + b2R_{on}I^2\mu(\theta, \phi). \quad (62)$$

*3) Average conduction losses:* Using (43), the average conduction losses of (62) are

$$p_{cond,avg}(\phi) = \sqrt{2}V_{on}Iv_{avg}(\phi) + b2R_{on}I^2\mu_{avg}(\phi), \tag{63}$$

where

$$v_{avg}(\phi) = \frac{1}{2\pi}\sum_{i=0}^{12d+2}\Delta\bar{s}_i(\cos(\bar{\alpha}_i + \phi) - \cos(\phi)) \tag{64a}$$

$$\mu_{avg}(\phi) = \frac{1}{8\pi}\sum_{i=0}^{12d+2}\Delta\bar{s}_i(\sin(\overline{2\alpha_i} + 2\phi) - 2\bar{\alpha}_i - \sin(2\phi) + 4\pi). \tag{64b}$$

*Constraint on the losses*

Different approaches exist to limit or minimize the converter losses in the optimization problems of OPPs with QaHWS, see (12), and OPPs with HWS, see (13). One option is to add the losses to the original objective function by discounting them with a weighting parameter. However, this leads to a rather unintuitive tuning parameter in the objective function. An easier and straightforward way is to bound the maximal losses in the optimization problem by adding an inequality constraint to the problem. This upper bound

can be directly derived from the thermal characteristics of the converter and its semiconductors.

Denote with $p_{sw,avg}^j$ and $p_{cond,avg}^j$ the average switching and conduction losses, respectively, of the $j$th device, which were defined in (44) and (63). Recall that $\Phi$ denotes the set of relevant displacement angles. To limit the total power losses in the converter, i.e., the sum of the switching and conduction losses of all semiconductors in one phase leg, we add one inequality constraint of the form

$$\sum_{j=1}^{10}\left(p_{sw,avg}^j(\phi) + p_{cond,avg}^j(\phi)\right) \leq p_{avg,lim,tot}, \quad \forall\phi \in \Phi \tag{65}$$

per displacement angle. Alternatively, we can limit the losses of each semiconductor switch separately with 10 constraints per displacement angle, i.e.,

$$p_{sw,avg}^j(\phi) + p_{cond,avg}^j(\phi) \leq p_{avg,lim}^j, \quad \forall j \in \{1,2,\ldots,10\}, \phi \in \Phi. \tag{66}$$

In both cases, the average losses over a fundamental period are constrained. See Fig. 4 for an example.

Alternatively, we may limit the peak losses of a semiconductor device. The peak switching losses of the $j$th semiconductor, for example, can be limited by constraining the switching energy losses at each switching transition and for each relevant displacement angle by

$$e_{sw,i}^j(\phi) \leq e_{sw,lim}, \quad \forall i \in \{1,2,\ldots,4d\}, \phi \in \Phi, \tag{67}$$

where the ith switching energy loss is

$$e_{sw,i}(\phi) = \frac{1}{2}v_{dc}c_if(\alpha_i, \phi). \tag{68}$$

This equation can be easily derived by inserting (42) into (38) and by integrating the expression. Recall that $\alpha_i \in A_a$, where $A_a$ denotes the set of single-phase switching angles over a fundamental period. Similar statements can be used to limit any peak loss, including turn-on, turn-off, reverse-recovery or conduction losses. For the latter, a slightly more generic set of constraints of the form

$$p_{cond}^{j}(\theta, \phi) \leq p_{peak,lim}^{j}, \quad \forall \theta \in \Theta_p, \phi \in \Phi \qquad (69)$$

could be used for the $j$th semiconductor device, where $\Theta_p$ is a set of angles, which includes the set of switching angles $A_a$ and possibly additional angles, at which the peak value of the conduction losses might occur.

LIMITING THE SEMICONDUCTOR JUNCTION TEMPERATURES

*Junction temperature model*

First, denote with

$$p_{loss}(\theta, \phi) = p_{sw}(\theta, \phi) + p_{cond}(\theta, \phi) \qquad (70)$$

the total semiconductor losses of one semiconductor.

Fig. 10 shows a Foster thermal model of the heat transfer through a semiconductor module. The model consists of $n$ resistor-capacitor segments. The Foster model allows one to model the steady-state (and even transient) junction-to-water temperature drop $T_{j-w}$ given the (instantaneous) losses $p_{loss}$ of a device. More specifically, the instantaneous (dc-component plus ripple) temperature can be computed. Note that this method is not limited to only the Foster model; other models, such as the Cauer model, can also be used. Although not shown, cross coupling between devices can easily be considered.

In the frequency domain, the thermal model is

$$T_{j-w}(s, \phi) = P_{loss}(s, \phi)Z_{TH}(s), \qquad (71)$$

where s is the complex variable, and the equivalent Foster thermal impedance is

$$Z_{TH}(s) = \sum_{i=1}^{n} \frac{R_i}{R_i C_i s + 1}.$$

In the time-domain, the Foster model can be described with $n$ differential equations and an output equation. With the state vector

$$\boldsymbol{T}(\theta, \phi) = [T_1(\theta, \phi) \quad T_2(\theta, \phi) \quad \dots \quad T_n(\theta, \phi)]^{\mathrm{T}}, \qquad (72)$$

the state-space model follows as

$$\frac{d\boldsymbol{T}(\theta, \phi)}{d\theta} = \boldsymbol{F}\boldsymbol{T}(\theta, \phi) + \boldsymbol{G}p_{loss}(\theta, \phi) \qquad (73a)$$

$$T_{j-w}(\theta, \phi) = \mathbf{1}_n^T \boldsymbol{T}(\theta, \phi), \qquad (73b)$$

where

$$F = \begin{bmatrix} \dfrac{-1}{R_1 C_1} & 0 & \cdots & 0 \\ 0 & \dfrac{-1}{R_2 C_2} & \cdots & \\ \vdots & & \ddots & \vdots \\ 0 & 0 & \cdots & \dfrac{-1}{R_n C_n} \end{bmatrix} \dfrac{1}{\omega_1} \quad \text{and} \quad G = \begin{bmatrix} \dfrac{1}{C_1} \\ \dfrac{1}{C_2} \\ \vdots \\ \dfrac{1}{C_n} \end{bmatrix} \dfrac{1}{\omega_1}.$$

Here, $1_n \in \mathbb{Z}^n$ is a vector of ones. The angular fundamental frequency $\omega_1$ emerges by formulating the state-space model with respect to the angle $\theta$ rather than the time t.

*Average, instantaneous, and ripple temperatures*

We will derive expressions for the steady-state values of the average, instantaneous and ripple temperatures.

*1) Average temperature:* Calculating the average temperature $T_{j\text{-}w,avg}$ is straightforward. We set (71) to its dc-value by setting s = 0 rad/s, i.e.,

$$T_{j-w}(0, \phi) = P_{loss}(0, \phi) Z_{TH}(0), \tag{75}$$

where

$$Z_{TH}(0) = \sum_{i=1}^{n} R_i. \tag{76}$$

Thus, the dc-component (or average value) of the steady-state temperature is

$$T_{j-w,avg}(\phi) = p_{loss,avg}(\phi) \sum_{i=1}^{n} R_i \tag{77}$$

with the average switching and conduction losses as in (44) and (63).

*2) Instantaneous temperature:* One well-known way to calculate the instantaneous temperature during steady-state operation is to use a Fourier series. However, this requires summing up a finite number of harmonics; the more harmonics are considered, the more accurate a Fourier series representation is. This implies a trade-off between accuracy and computational burden. Due to the truncation of the sums, the Fourier series suffers from the so-called Gibbs effect, which - during numerical optimization - may lead to false stationary points and numerical inaccuracies.

Instead, we propose to calculate the instantaneous temperature during steady-state operation by first solving the initial condition of the underlying differential equations. Then, using the solutions of the differential equations, the temperature can be (exactly) computed at any angle $\theta$. This method does not suffer from any numerical inaccuracies and is computationally efficient, thus, avoiding the inherent drawbacks of the classic Fourier series approach.

By integrating (73) the temperature state vector at the angle $\theta$ is

$$T(\theta, \phi) = e^{F\theta} T(0, \phi) + \int_0^{\theta} e^{F(\theta-\varphi)} G p_{loss}(\varphi, \phi) \mathrm{d}\varphi. \tag{78}$$

As stated earlier, the idea is now to calculate the initial steady-state temperature $T(0,\phi)$, from which any (steady-state) temperature can be computed at an arbitrary angle $\theta \in [0,2\pi]$. Key to computing $T(0,\phi)$ is the fact that the temperature is periodic in the fundamental period, i.e.,

$$T(0,\phi) = T(2\pi,\phi)$$

holds during steady-state conditions. The calculations of the steady-state trajectory is shown below. Once $T(\theta,\phi)$ for $\theta \in [0,2\pi]$ has been determined, the junction-to-water temperature follows from (73b) as

$$T_{j-w}(\theta,\phi) = \mathbf{1}_n^T T(\theta,\phi). \qquad (79)$$

*3) Ripple temperature:* The ripple temperature is defined as the instantaneous temperature minus the average temperature, i.e.,

$$T_{j-w,rip}(\theta,\phi) = T_{j-w}(\theta,\phi) - T_{j-w,avg}(\phi), \qquad (80)$$

where the instantaneous and the ripple temperature is given by (79) and (77), respectively.

*Constraint on the device temperature*

Denote with $T_{j-w}^{j}$ the junction-to-water temperature of the *j*th device. The water temperature is denoted with $T_w$. Recall that $\Phi$ denotes the set of relevant displacement angles. There is a variety of ways the temperature can be constrained. Namely, the average, the ripple, and/or the peak temperature can be constrained.
In case of the average temperature, the constraints are of the form

$$T_{j-w,avg}^{j}(\phi) + T_w \leq T_{avg,lim}^{j}, \quad \forall j \in \{1,2,\dots,10\}, \phi \in \Phi. \qquad (81)$$

Similarly, the ripple or the peak (instantaneous) temperature can be constrained by

$$T_{j-w,rip}^{j}(\theta,\phi) \leq T_{rip,lim}^{j}, \quad \forall j \in \{1,2,\dots,10\}, \theta \in A_a, \phi \in \Phi, \qquad (82)$$

$$T_{j-w}^{j}(\theta,\phi) + T_w \leq T_{lim}^{j}, \quad \forall j \in \{1,2,\dots,10\}, \theta \in A_a, \phi \in \Phi, \qquad (83)$$

respectively. Recall that $A_a$ denotes the set of single-phase switching transitions over a fundamental period. Note that, due to the high switching losses of medium-voltage converters, it is highly likely that the peaks of the ripple and instantaneous temperatures will occur at a switching transition. For this reason, these constraints are imposed at the set of switching angles $A_a$, but additional constraints at intermediate angles could be considered as well.

STEADY-STATE TRAJECTORY OF THE INSTANTANEOUS TEMPERATURE

Due to the linearity, the temperature of a semiconductor device can be decomposed into its conduction and switching-loss components,

$$T(\theta,\phi) = T_{sw}(\theta,\phi) + T_{cond}(\theta,\phi), \qquad (84)$$

where

$$T_{sw}(\theta, \phi) = e^{F\theta} T_{sw}(0, \phi) + \int_0^\theta e^{F(\theta-\vartheta)} G p_{sw}(\vartheta, \phi) \mathrm{d}\vartheta \qquad (85a)$$

$$T_{cond}(\theta, \phi) = e^{F\theta} T_{cond}(0, \phi) + \int_0^\theta e^{F(\theta-\vartheta)} G p_{cond}(\vartheta, \phi) \mathrm{d}\vartheta. \qquad (85b)$$

First consider the switching losses component. Recall from (42) that

$$p_{sw}(\theta, \phi) = \omega_1 \frac{v_{dc}}{2} \sum_{i=1}^{4d} c_i f(\theta, \phi) \delta(\theta - \alpha_i).$$

Using the shifting property of the impulse,

$$\int_{-\infty}^x f(x)\delta(x-a)dx = f(a)h(x-a),$$

the integral of (85a) can easily be solved, and

$$T_{sw}(\theta, \phi) = e^{F\theta} T_{sw}(0, \phi) + \omega_1 \frac{v_{dc}}{2} \sum_{i=1}^{4d} e^{F(\theta-\alpha_i)} c_i f(\alpha_i, \phi) h(\theta - \alpha_i) G. \qquad (86)$$

Then, with $0 = 2\pi$,

$$T_{sw}(2\pi, \phi) = e^{F2\pi} T_{sw}(0, \phi) + \omega_1 \frac{v_{dc}}{2} \sum_{i=1}^{4d} e^{F(2\pi-\alpha_i)} c_i f(\alpha_i, \phi) G,$$

and due to that fact $T_{sw}(0,\phi) = Ts_w(2\pi,\phi)$ holds during steady-state operation,

$$T_{sw}(0, \phi) = e^{F2\pi} T_{sw}(0, \phi) + \omega_1 \frac{v_{dc}}{2} \sum_{i=1}^{4d} e^{F(2\pi-\alpha_i)} c_i f(\alpha_i, \phi) G$$

follows. The initial value can then be calculated as

$$T_{sw}(0, \phi) = (\mathbf{I}_n - e^{F2\pi})^{-1} \omega_1 \frac{v_{dc}}{2} \sum_{i=1}^{4d} e^{F(2\pi-\alpha_i)} c_i f(\alpha_i, \phi) G. \qquad (87)$$

After inserting (87) into (86), the temperature due to the switching loss component can be calculated at any angle $\theta$.

Next, consider the conduction losses component. Recall from (62) that the conduction losses are

$$p_{cond}(\theta, \phi) = \sqrt{2} V_{on} I v(\theta, \phi) + b2R_{on} I^2 \mu(\theta, \phi), \qquad (88)$$

where

$$v(\theta, \phi) = \sum_{i=0}^{12d+2} \Delta \bar{s}_i h(\theta - \bar{\alpha}_i) \sin(\theta + \phi)$$

$$\mu(\theta, \phi) = \frac{1}{2} \sum_{i=0}^{12d+2} \Delta \bar{s}_i h(\theta - \bar{\alpha}_i)\big(1 - \cos(2(\theta + \phi))\big).$$

Here, the fact that $\sin^2(\theta + \phi) = \frac{1}{2}\big(1 - \cos(2(\theta + \phi))\big)$ is used. Inserting (88) into (85b) results in

$$T_{cond}(\theta, \phi) = e^{F\theta} T_{cond}(0, \phi) + \int_0^\theta e^{F(\theta - \vartheta)} G\left(\sqrt{2}V_{on}Iv(\theta, \phi) + b2R_{on}I^2\mu(\theta, \phi)\right) d\vartheta$$

$$= e^{F\theta} T_{cond}(0, \phi) + \sqrt{2}V_{on}I\eta(\theta, \phi) + bR_{on}I^2(\rho(\theta, \phi) - \kappa(\theta, \phi)) \qquad (89)$$

where

$$\eta(\theta, \phi) = \sum_{i=0}^{12d+2} \Delta \bar{s}_i \int_{\bar{\alpha}_i}^\theta e^{F(\theta - \vartheta)} \sin(\vartheta + \phi)\, d\vartheta Gh(\theta - \bar{\alpha}_i) \qquad (90a)$$

$$\kappa(\theta, \phi) = \sum_{i=0}^{12d+2} \Delta \bar{s}_i \int_{\bar{\alpha}_i}^\theta e^{F(\theta - \vartheta)} \cos(2(\vartheta + \phi))\, d\vartheta Gh(\theta - \bar{\alpha}_i) \qquad (90b)$$

$$\rho(\theta) = \sum_{i=0}^{12d+2} \Delta \bar{s}_i \int_{\bar{\alpha}_i}^\theta e^{F(\theta - \vartheta)} d\vartheta Gh(\theta - \bar{\alpha}_i) \qquad (90c)$$

where that fact that a step function changes the lower bound of an integral as

$$\int_{-\infty}^x f(x)h(x - a)dx = \int_a^x f(x)dx h(x - a)$$

is used. The integrals of (90a) and (90b) can be solved via integration by parts, whereas (90c) is straightforward to integrate:

$$\eta(\theta, \phi) = \sum_{i=0}^{12d+2} \Delta \bar{s}_i \big(M(\theta, \phi) - M(\bar{\alpha}_i, \phi)\big)Gh(\theta - \bar{\alpha}_i) \qquad (91a)$$

$$\kappa(\theta, \phi) = \sum_{i=0}^{12d+2} \Delta \bar{s}_i \big( N(\theta, \phi) - N(\bar{\alpha}_i, \phi) \big) Gh(\theta - \bar{\alpha}_i) \qquad (91b)$$

$$\rho(\theta) = F^{-1} \sum_{i=0}^{12d+2} \Delta \bar{s}_i \big( e^{F(\theta - \bar{\alpha}_i)} - I_n \big) Gh(\theta - \bar{\alpha}_i) \qquad (91c)$$

where

$$M(\vartheta, \phi) = -(I_n + F^2)^{-1} e^{F(\theta - \vartheta)} \big( F \sin(\vartheta + \phi) + I_n \cos(\vartheta + \phi) \big)$$

$$N(\vartheta, \phi) = (4I_n + F^2)^{-1} e^{F(\theta - \vartheta)} \big( 2I_n \sin(2(\vartheta + \phi)) - F \cos(2(\vartheta + \phi)) \big).$$

With $\theta = 2\pi$, (89) yields

$$T_{cond}(2\pi, \phi) = e^{F2\pi} T_{cond}(0, \phi) + V_{on}\sqrt{2} I \eta(2\pi, \phi) + bI^2 R_{on} \big( \rho(2\pi, \phi) - \kappa(2\pi, \phi) \big),$$

where the results of (91) can be used. Again, using the fact $T_{cond}(0,\phi) = T_{cond}(2\pi,\phi)$, in initial value can be calculated as

$$T_{cond}(0, \phi) = (I_n - e^{F2\pi})^{-1} \left( V_{on}\sqrt{2} I \eta(2\pi, \phi) + bI^2 R_{on} \big( \rho(2\pi, \phi) - \kappa(2\pi, \phi) \big) \right). \quad (92)$$

After inserting (92) into (89), the temperature due to the conduction loss component can be calculated at any angle $\theta$.

The temperature due to the switching and conduction losses follows from (84).

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

**Claims**

1.  A method for computing an optimized pulse pattern (20) for an electrical converter (18),

    wherein the optimized pulse pattern (20) comprises a series of switching transitions, each switching transition comprising a switching angle ($\alpha_i$) and a switch position ($u_i$);
    wherein the switching angles ($\alpha_i$) are computed by minimizing a total demand distortion of a load current produced by the optimized pulse pattern (20), wherein an objective function is minimized, which models the total demand distortion of a load current in dependence of the switching angles ($\alpha_i$) and switch positions ($u_i$);
    wherein the total demand distortion of the load current is minimized subject to at least one additional constraint, which limits a turn-off current, a switching loss, a temperature and/or a voltage to be blocked for a set of semiconductor devices (26) of the electrical converter (18).

2.  The method of claim 1,

    wherein the turn-off current, the switching loss, the temperature and/or the voltage to be blocked depends on

the switching angles ($\alpha_i$) and the switch positions ($u_i$); and/or
wherein at least one additional constraint is present for each semiconductor device (26) from the set of semiconductor devices.

3. The method of claim 1 or 2,
wherein the turn-off current, the switching loss, the temperature and/or the voltage to be blocked depends on a displacement angle ($\phi$), which is the phase of a fundamental component of the load current with respect to a fundamental voltage component of an output voltage produced by the optimized pulse pattern, and the constraints are imposed with respect to a set of relevant displacement angles.

4. The method of one of the previous claims,
wherein the total demand distortion of the load current is minimized subject to current limiting constraints that ensure that a peak current produced by the optimized pulse pattern at each switching transition is smaller than a limiting current.

5. The method of one of the previous claims,

wherein the total demand distortion of the load current is minimized subj ect to loss constraints that ensure that semiconductor losses ( $p_{sw}^j$, $p_{cond}^j$ ) are smaller than limiting losses;
wherein a semiconductor loss is determined for each semiconductor device (26) from the set of semiconductor devices;
wherein the semiconductor loss of a semiconductor device (26) is the sum of a switching loss and a conduction loss of the semiconductor device.

6. The method of claim 5,

wherein, for each semiconductor device (26) of the set of semiconductor devices, a loss constraint is present that ensures that the semiconductor loss of the semiconductor device (26) is smaller than a limiting loss ( $p_{lim}^j$ ) for the semiconductor device; or
wherein a loss constraint is present that ensures that the sum of semiconductor losses of the set of semiconductor devices is smaller than an overall limiting loss ($p_{tot,lim,}$).

7. The method of one of the previous claims,

wherein the total demand distortion of the load current is minimized subject to temperature constraints that ensure that average temperatures ( $T_{j-w,avg}^j$ ), instantaneous temperatures ( $T_{j-w}^j$ ), and/or temperature ripples ( $T_{j-w,rip}^j$ ) of semiconductor devices are smaller than limiting temperatures;
wherein an average temperature, an instantaneous temperature, and/or a temperature ripple is determined for each semiconductor device from the set of semiconductor devices.

8. The method of claim 7,
wherein, for each semiconductor device (26) of the set of semiconductor devices, at least one temperature constraint is present that ensures that the average temperature, instantaneous temperature, and/or temperature ripple of the semiconductor device is smaller than a limiting temperature.

9. The method of one of the previous claims,

wherein the total demand distortion of the load current is minimized subject to a neutral-point potential constraint that ensures that a neutral-point potential is smaller than a limiting neutral-point voltage; and/or
wherein the total demand distortion of the load current is minimized subject to a dc-link ripple constraint that ensures that a dc-link ripple is smaller than a limiting dc-link ripple voltage.

10. The method of one of the previous claims,

wherein the total demand distortion of the load current is minimized subject to the constraint that the order of the switching transitions is fixed.

11. The method of one of the previous claims,
    wherein the total demand distortion of the load current is minimized subject to the constraint that an amplitude of a fundamental component ($\hat{u}_1$) of the load current is equal to a modulation index ($m$).

12. A method for controlling an electrical converter (18), the method comprising:

    computing optimized pulse patterns (20) according to one of the claims 1 to 11 for a plurality of pulse numbers ($d$) and modulation indices ($m$);
    storing the optimized pulse patterns (20) in a controller (16) of the electrical converter (18);
    controlling, with the controller (16), the electrical converter (18) with the optimized pulse patterns (20).

13. A computer program, which, when being executed on at least one processor, is adapted for performing the method of one of claims 1 to 12.

14. A computer-readable medium, in which a computer program according to claim 13 is stored.

15. A computing device (14, 16) adapted for performing the method of one of claims 1 to 12.

# Fig. 1

# Fig. 2

# Fig. 3

Angle θ [rad]

# Fig. 4

Displacment angle Ø [°]

## Fig. 5

## Fig. 6

# Fig. 7

Angle θ [rad]

Angle θ [rad]

# Fig. 8

# Fig. 9

# Fig. 10

Europäisches
Patentamt

European
Patent Office

Office européen
des brevets

## EUROPEAN SEARCH REPORT

Application Number

EP 22 20 4176

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GEYER TOBIAS ET AL: "Model Predictive Pulse Pattern Control of Medium-Voltage Neutral-Point-Clamped Inverter Drives", 2018 IEEE ENERGY CONVERSION CONGRESS AND EXPOSITION (ECCE), IEEE, 23 September 2018 (2018-09-23), pages 5047-5054, XP033463420, DOI: 10.1109/ECCE.2018.8557349 [retrieved on 2018-12-03] * abstract; figures 1, 3, 9 * * Section III. A Offline Computation, Section III. B. Outer Control Loops, Section IV. C. Steady State Operation, Section V. Current Distortion vs Switching Frequency. * ----- | 1-15 | INV. H02M7/487 |
| X | TOBIAS GEYER ET AL: "Model predictive pulse pattern control", 2011 IEEE ENERGY CONVERSION CONGRESS AND EXPOSITION, 1 September 2011 (2011-09-01), pages 3306-3313, XP055015597, DOI: 10.1109/ECCE.2011.6064215 ISBN: 978-1-45-770542-7 * abstract * * Section IV. A. Stator Flux Control Problem; figures 1, 6 * ----- -/-- | 1-15 | |

TECHNICAL FIELDS
SEARCHED (IPC)

H02M

The present search report has been drawn up for all claims

| Place of search | Date of completion of the search | Examiner |
|---|---|---|
| The Hague | 20 March 2023 | Van der Meer, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**Europäisches Patentamt**
**European Patent Office**
**Office européen des brevets**

# EUROPEAN SEARCH REPORT

Application Number

EP 22 20 4176

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BIRTH ANNIKA ET AL: "Symmetry Relaxation of Three-Level Optimal Pulse Patterns for Lower Harmonic Distortion", 2019 21ST EUROPEAN CONFERENCE ON POWER ELECTRONICS AND APPLICATIONS (EPE '19 ECCE EUROPE), EPE ASSOCIATION, 3 September 2019 (2019-09-03), XP033665528, DOI: 10.23919/EPE.2019.8915078 [retrieved on 2019-11-26] * the whole document * | 1-15 | |

-----

TECHNICAL FIELDS
SEARCHED (IPC)

The present search report has been drawn up for all claims

| Place of search | Date of completion of the search | Examiner |
|---|---|---|
| The Hague | 20 March 2023 | Van der Meer, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)